# EUROPEAN PATENT SPECIFICATION

(11) **EP 2 186 917 B1**
(45) Date of publication and mention of the grant of the patent: **21.04.2021**
(21) Application number: 08791262.2
(22) Date of filing: 17.07.2008
(51) Int. Cl.: C22C 1/04, B22F 3/14, C22C 12/00, C22C 28/00, C23C 14/34, B22F 7/04, H01J 37/34

(54) **METHOD FOR PRODUCING SINTERED BODY, SINTERED BODY, SPUTTERING TARGET COMPOSED OF THE SINTERED BODY, AND SPUTTERING TARGET-BACKING PLATE ASSEMBLY**
VERFAHREN ZUR HERSTELLUNG EINES SINTERKÖRPERS, SINTERKÖRPER, AUS DEM SINTERKÖRPER BESTEHENDES SPUTTERTARGET UND SPUTTERTARGET-TRÄGERPLATTE-ANORDNUNG
PROCÉDÉ DE PRODUCTION DE CORPS FRITTÉ, CORPS FRITTÉ, ET CIBLE DE PULVÉRISATION CONSTITUÉE DU CORPS FRITTÉ, ET ENSEMBLE CIBLE DE PULVÉRISATION-PLAQUE SUPPORT

(30) Priority: 13.09.2007 JP 2007238135; 05.03.2008 JP 2008054397
(43) Date of publication of application: 19.05.2010
(73) Proprietor: JX Nippon Mining & Metals Corporation, Tokyo 105-8417 (JP)
(72) Inventor: TAKAHASHI, Hideyuki, Kitaibaraki-shi Ibaraki 319-1535 (JP)
(74) Representative: Forresters IP LLP
(86) International application number: PCT/JP2008/062908
(87) International publication number: WO 2009/034775

(56) References cited:
- WO-A1-2006/059429
- WO-A1-2006/059429
- WO-A1-2006/077692
- JP-A- 05 311 423
- JP-A- 2004 162 109
- JP-A- 2004 162 109
- US-A1- 2007 099 332

## Description

### TECHNICAL FIELD

The present invention relates to a method of producing a high-density, high-strength and large-diameter sintered compact containing a Vb group element (A) and a chalcogenide element (B) or containing the elements (A) and (B) and additionally a IVb group element (C) and/or an additive element (D). The present invention additionally relates to such a sintered compact, a sputtering target formed from the sintered compact, and a sputtering target-backing plate assembly.

### BACKGROUND ART

In recent years, a thin film formed from a Ge-Sb-Te-based material is being used as a material for use in phase change recording; that is, as a medium for recording information by using phase transformation.

As a method of forming this thin film formed from the Ge-Sb-Te-based alloy material, a means generally referred to as a physical vapor deposition method such as the vacuum deposition method or the sputtering method is commonly used. Especially, the magnetron sputtering method is used frequently for its operability and film stability.

Formation of films by way of the sputtering method is performed by physically colliding positive ions such as Ar ions to a target disposed on a cathode, using that collision energy to discharge materials configuring the target, and laminating a film having roughly the same composition as the target material on the opposite anode- side substrate.

The coating method based on the sputtering method is characterized in that it is possible to form films of various thicknesses; for instance, from a thin film of angstrom units to a thick film of tens of µm, with a stable deposition rate by adjusting the processing time, power supply and the like.

Conventionally, in order to inhibit the generation of particles that occurs in the sputtering process, a high-density sintered compact having a diameter of 280mm and a relative density of 98.8% was prepared by sintering, via hot press, raw material powder having high purity and a prescribed grain size.

Even when this high-density sintered compact was assembled and used as a sputtering target, cracks and the like resulting from the thermal expansion with the backing plate would not occur, and warping was within a tolerable range.

Nevertheless, since a sintered compact that is sintered by combining a chalcogenide element (S, Se, Te), a Vb group element (Bi, Sb, As, P, N), and additionally a IVb group element (Pb, Sn, Ge, Si, C) and an additive element (Ag, Au, Pd, Pt, B, Al, Ga, In, Ti, Zr) is extremely fragile, when attempting to produce a large-diameter sintered compact, it was impossible to produce a large-diameter sintered compact having high density and high strength.

In addition, under the conventional sintering conditions, even if it is possible to increase the density, the deflecting strength is insufficient, and it could not be used as a sputtering target due to occurrence of cracks and apparent warping when assembled and used as a sputtering target. Reference Patent Documents are listed below.

In addition, the deflecting strength is a reflection of the strength of the grain boundary, and, if this strength is weak, there is a problem in that the particles would desorb during the sputtering process, thereby causing the generation of particles. Moreover, since the sputter rate will differ if the composition of the respective crystal grains is different, there are problems in that the erosion becomes uneven, micro nodules are formed, micro arcing is generated with the micro nodules as the origin or particles are generated based on the dispersion of the micro nodules themselves, and at worst, the target would crack due to thermal shock. The larger the diameter is, the greater the influence and the more serious the problem becomes.
[Patent Document 1] Japanese Patent Laid-Open Publication No.2000-265262
[Patent Document 2] Japanese Patent Laid-Open Publication No.2001-98366 [Patent Document 3] Japanese Patent Laid-Open Publication No.2001-123266
[Patent Document4] Japanese Patent Laid-Open Publication No.H3-180468 [Patent Document 5] Japanese Patent Laid-Open Publication No.H10-81962

JP 2004 162109 discloses an Sb-Te sputtering target having an average crystal particle size of 20 µm or lower, a bending strength of 60 MPa or higher, and an oxygen content of 1,000 ppm or lower.

### DISCLOSURE OF THE INVENTION

The present invention provides a method of producing a sintered compact, a sintered compact and a sputtering target formed from the same, as claimed.

Conventionally, when producing a sintered compact or a sputtering target using raw material powder containing a chalcogenide element (A) and a Vb group element (B) or raw material powder additionally containing a IVb group element (C) or a required additive element (D), if a large-diameter sputtering target is prepared and bonded with a backing plate, there was a problem in that cracks would occur on the surface or the target itself would crack due to the difference in thermal expansion, because the sintered compact would become extremely fragile.

The present invention yields a superior effect of producing a high-strength, high-density and large-diameter sintered compact or sputtering target by improving the production process, wherein cracks do not occur even when the target is bonded to the backing plate, and with the warping being within a tolerable range. In addition, since the structure of the sintered compact target can be refined and the uniformity of the composition can be sought, the present invention yields a significant effect of reducing the generation of nodules and particles.

### BEST MODE FOR CARRYING OUT THE INVENTION

### (Sintering raw material and control of pressure rise and temperature rise conditions of hot press)

As described above, upon producing a sintered compact, the following steps are performed; namely, mixing raw material powder composed of the respective elements or raw material powder of an alloy of two or more elements, and hot pressing the mixed powder under conditions that satisfy the following formula: P(pressure) ≦{Pf/(Tf-T₀)} × (T-T₀) + P₀ (Pf: final pressure, Tf: final temperature, P₀: atmospheric pressure, T: heating temperature, T₀: room temperature, and temperatures are in Celsius);
(A): one or more chalcogenide elements selected from S, Se, and Te
(B): one or more Vb group elements selected from Bi, Sb, As, P, and N
   In addition the following element (C) or element (D) is added, if needed.
(C): one or more IVb group elements selected from Pb, Sn, Ge, Si, and C
(D): one or more elements selected from Ag, Au, Pd, Pt, B, Al, Ga, In, Ti, and Zr

Consequently, produced is a sintered compact containing a chalcogenide element (A) and a Vb group element (B), or a sintered compact containing a chalcogenide element (A) and a Vb group element (B) as well as a IVb group element (C) or a required additive element (D).

The present invention is based on controlling the pressure rise and temperature rise conditions of the hot press, and is achieved by relatively and gradually increasing the pressure P in relation to the temperature T in the course of the temperature rise. Deviating from these conditions, it is virtually impossible to produce a large-diameter sintered compact or sputtering target having high strength and high density.

In the raw material synthesizing process, for instance, Sb as the Vb group element is added to Te as the chalcogen element; if needed, Ge as the IVb group element and the additive element (D) above are additionally added, melted and solidified to obtain a compound of binary or more, and pulverized with a ball mill to obtain raw material powder.

In many cases, Te as the chalcogenide element (A), Sb as the Vb group element (B), and Ge as the IVb group element (C) are used. However, so as the elements are in the same group, they show similar characteristics, and therefore, obviously, chalcogenide elements (A), Vb group elements (B), IVb group elements (C) and additive elements (C) other than the foregoing element can also be used. The present invention covers all such elements.

In order to simplify the understanding of the present invention, the case of selecting Te as the chalcogenide element (A), Sb as the Vb group element (B), and Ge as the IVb group element (C) will used in the ensuing explanation.

Elements such as Te, Sb and Ge belonging to the chalcogenide element, Vb group, and IVb group of the present invention have a high vapor pressure, and there are cases where these binary or ternary compounds are formed as a complex compound; and then, the powder will have a composition that locally varies, and will not have a fixed softening point or melting point. Therefore, it is considered that if the composition of the respective powders is uniform, then a uniform softening point or melting point can be achieved, whereby an ideal sintered compact can be obtained.

Meanwhile, the softening and sintering phenomenon in the course of the temperature rise of the hot press is not so simple as the case of a single element metal, and it is considered that softening and sintering will advance locally at the various stages of the temperature and the pressure at the contact points of powders. The application of large pressure at a stage where the softening of powder is insufficient may cause unreasonable deformation and residual stress to the powder particles, and this will deteriorate the bonding strength at the grain boundary even if the density is ultimately increased, and this phenomena is considered to be the main cause of deteriorating the strength of the sintered compact.

In addition, these alloy system basically show the same fragile mechanical characteristics as ceramics, and have high crack sensitivity due to the uneven and coarse crystal structure. The deflecting strength is a reflection of the strength of the grain boundary, and, if the deflecting strength is weak, there is a problem in that the particles would desorb during the sputtering process, thereby causing the generation of particles. Moreover, since the sputter rate will differ if the composition of the respective crystal grains is different, there are problems in that the erosion becomes uneven, micro nodules are formed, micro arcing is generated with the micro nodules as the origin or particles are generated based on the dispersion of the micro nodules themselves, and, in a worst case scenario, the target would crack due to thermal shock.

The large-diameter sputtering target having a fine uniform crystal structure, uniform density, and high strength obtained based on the production method of the present invention is also effective even with a target in which the diameter of the sintered compact is 380mm or more, and inhibits and improves the particle generation rate of a conventional target having a diameter of 280mm. This is because the grain boundary of the sintered compact has been strengthened based on the fine uniform crystal structure and uniform density. This can only be achieved based on the foregoing condition of the present invention.

The essential basic conditions for achieving the present invention is to perform hot pressing under conditions that satisfy P(pressure) ≦ {Pf/(Tf-T₀)} × (T-T₀) + P₀, (Pf: final pressure, Tf: final temperature, P₀:atmospheric pressure, T: heating temperature, T₀: room temperature, temperatures are in Celsius), but it is effective to keep the pressure for 10 to 120 minutes in the course of the temperature T rising from 100 to 500°C. Moreover, it is desirable to keep the pressure for 10 to 120 minutes in the course of the temperature T rising from 200 to 400°C.

Consequently, it will be possible to gradually locally advance the softening and sintering where the powder and powder come in contact and further ensure uniform sinterability, which has effects to inhibit the deformation of the sintered compact and the generation of residual stress.

Though optimal sinterability can be obtained based on the sintering conditions; that is, the temperature and pressure of the hot press, keeping the pressure in the foregoing temperature range is one of the methods that allow for easy management during the production process.

Sintering is desirably performed in a vacuum or an inert gas atmosphere in order to prevent the mixture and adsorption of gas components.

Although the hot pressing pressure and temperature can be changed based on the component composition of the sintered compact, under normal circumstances, it is desirable to set the final pressure Pf to 100 to 300kgf/cm², and the final temperature Tf to 500 to 650°C. Sintering can also be performed outside of the foregoing range, but the foregoing conditions are recommended upon sintering raw material powder composed of the respective elements of chalcogenide element (A) and Vb group element (B), or raw material powder composed of the respective elements of IVb group element (C) or additive element (D) additionally added thereto, or raw material powder of an alloy composed of two or more elements.

It is also effective to set the temperature rise rate from the room temperature to the final temperature Tf to be 10°C/min, cause the softening and sintering to advance gradually, and thereby ensure uniform sinterability. This is also a condition that is recommended upon sintering raw material powder (the term "raw material powder" as used herein includes the powder, alloy powder, compound powder, and mixture of the respective elementary substances, but the description of these forms is omitted unless it is necessary to specifically indicate the same) composed of the respective elements of chalcogenide element (A) and Vb group element (B) or the raw material powder of IVb group element (C) additionally added thereto.

### (Adjustment of purity and grain size of raw material)

As a result of adopting the sintering method of the present invention, it is possible to provide a sputtering target which is free from a streaked pattern caused by the alignment of coarse grains (this is generally referred to as a "macro pattern"), and the surface roughness Ra is 0.4µm or less.

This can be effectively achieved by optimizing the average grain size of the raw material powder composing the sintered compact with the pulverization method to be 0.1µm to 50µm and have a maximum grain size of 90µm or less and a purity of 4N or higher, and performing sintering according to the foregoing method. In addition, as a method of making the composition of the raw material powder to be uniform, this can be achieved by controlling the rate, fluctuation and other factors during the melting and solidification of the alloy, and thereby preventing gravity segregation and the like.

The macro pattern that sometimes occurs in the sintered compact is considered to be a result of performing uniaxial pressure sintering such as hot pressing to raw material powder containing large powder (coarse grains) in the vertical direction, whereby the coarse grains are aligned in parallel to the die face.

The macro pattern portion does not necessarily have particularly low density or strength. However, even with the slight difference in density between such macro pattern and the other peripheral portions, a stress concentrated part may arise as a result of the difference in thermal expansion between the target and the backing plate upon processing the sputtering target and bonding it with the backing plate to produce a backing plate assembly, and consequently result in a crack.

Moreover, this macro pattern sometimes affects the erosion during the sputtering. Thus, it could be said that it is desirable to adopt the foregoing conditions in order to inhibit the generation of this macro pattern.

### (Adjustment of surface roughness)

Upon processing a sputtering target, it is effective to reduce the surface roughness by performing grinding process and polishing process so as to reduce the residual stress on the target surface in order to prevent the stress concentrated part caused by the foregoing difference in thermal expansion.

In light of the above, it is desirable to set the surface roughness Ra to 0.4µm or less. In particular, with a sintered compact having the foregoing macro pattern, wave-shaped swelling will occur after the polishing process, and it will be subject to an additional adverse effect of not being able to be surface-processed into a flat shape. As described above, the inhibition of the macro pattern and the adjustment of the surface roughness are favorable conditions in producing a good target.

### (Adjustment of thickness of bonding layer)

When preparing an assembly by bonding a sputtering target to a backing plate, a bonding material such as indium is thickened in order to cause the bonding layer to absorb the stress and warping caused by the difference in thermal expansion during the bonding or sputtering process.

Even if the sintered compact as the sputtering target has high strength, if a large-sized target does not have an interference layer, it might not crack, but the peripheral portion will peel off. In addition, since a thick bonding layer has the effect of inhibiting the local heat generation during sputtering and tends to maintain the overall target at a uniform temperature, it is able to effectively prevent the generation of cracks that occur especially in last stages of the sputtering process.

In light of the above, when preparing the sputtering target-backing plate assembly of the present invention, the sputtering target is bonded with a copper alloy or aluminum alloy backing plate via a low-melting-point metal bonding layer. The thickness of the bonding layer is normally 0.4 to 1.4mm. In the foregoing case, indium is the recommended low-melting-point metal bonding material.

If the thickness of the bonding layer is too thick, the indium will be mechanically extruded pursuant to the target expansion caused by the heat generation during the sputtering, the extruded indium will fall or protrude to the peripheral part of the target. Thus, a redeposited film will be formed on such part and, as a result of this redeposited film peeling off, the number of particles will increase. Thus, as described above, the bonding layer thickness being 0.4mm to 1.4mm is a favorable condition. Nevertheless, there is no particular limitation on the bonding layer thickness unless there are concerns as those described above, and the bonding layer thickness may be suitably selected.

Moreover, since the purity of the alloy sintered compact sputtering target of the present invention has been improved, impurities other than the main component or additive accessory components; namely, oxides and the like will decrease and, therefore, it is possible to inhibit the abnormal discharge (arcing) originating from such impurities.

The present invention has a purity of 4N or higher, and is able to effectively prevent arcing caused by the foregoing impurities. Consequently, it is possible to inhibit the generation of particles caused by the arcing. Desirably the purity is 5N or higher.

Further, it is desirable to keep the content of gas components as impurities to be 2000ppm or less. The inclusion of gas components such as oxygen, nitrogen, carbon in excess of the foregoing value will cause the generation of impurities such as oxides, nitrides, and carbide. Thus, the reduction of gas components will prevent arcing and thereby inhibit the generation of particles caused by the arcing. This is not a particularly needed condition in the present invention, but it is one of the preferable conditions.

The Sb-Te-based alloy sintered compact sputtering target of the present invention may contain, at maximum 20at%, one or more elements selected from Ag, Au, Pd, Pt, B, Al, Ga, In, Ti, and Zr as additive elements. So as long as the amount is within the foregoing range, in addition to obtaining the intended glass transition temperature, transformation rate and electrical resistance value, it is also possible to minimize the surface defects resulting from the machining process, and the particles can also be effectively inhibited.

Generally speaking, the erosion surface after sputtering is a coarse surface having a surface roughness Ra of 1µm or more, and tends to become coarser pursuant to the progress of the sputtering process. However, with the target of the present invention having a crystal grain size of 10µm or less, the surface roughness Ra of the erosion surface after sputtering is 0.4µm or less, and it is possible to prevent protrusions that become the source of micro arcing and the adhesion of redeposited films, and it is thereby possible to obtain a sputtering target capable of effectively inhibiting the particles.

Based on the above, it is possible to obtain a sintered compact having a diameter of 380mm or more and a thickness of 20mm or less containing a chalcogenide element (A) and a Vb group element (B) and, as needed, additionally containing a IVb group element (C) and/or additive element (D).

Consequently, it is possible to obtain a sintered compact composed of a chalcogenide element (A) and a Vb group element (B) or a sintered compact composed of a chalcogenide element (A) and a Vb group element (B) as well as a IVb group element (C) and/or additive element (D) having a sintered structure in which the average grain size is 50µm or less, the deflecting strength is 40MPa or more, the relative density is 99% or higher, and the standard deviation of the in-plane density of the sintered compact surface is less than 1%.

The sputtering target produced from the sintered compact obtained as described above is free from cracks even when it is bonded to a backing plate, and yields a superior effect of also maintaining the warping within a tolerable range.

As described above, a target having a uniform fine crystal structure will have reduced surface irregularities caused by sputter erosion, and is able to effectively inhibit the generation of particles caused by the redeposited film on the target surface peeling off. In addition, as a result of achieving a finer structure, the sputtered film is also able to suppress the variation in composition in the plane and between lots, and yields an advantage of achieving stable quality. Consequently, it is possible to effectively inhibit the generation of particles, abnormal discharge, and nodules during the foregoing sputtering process.

With the sputtering target of the present invention, it is possible to make the gas component content of oxygen or the like to be 2000ppm or less, in particular 1000ppm or less, and even 500ppm or less. The reduction of gas components such as oxygen is effective in further reducing the generation of particles and the generation of abnormal discharge.

### [Examples]

The present invention is now explained in detail with reference to the Examples. These Examples are merely illustrative, and the present invention shall in no way be limited thereby. In other words, various modifications and other embodiments based on the technical spirit claimed in the claims shall be included in the present invention as a matter of course.

### (Example 1)

The raw material powders of Te, Sb and Ge respectively having a purity of 99.995 (4N5) excluding gas components were melted to obtain a composition of Ge₂₂Sb₂₂Te₅₆, and slowly cooled in a furnace to prepare a cast ingot. The raw materials of the respective elements were subject to acid cleaning and deionized water cleaning prior to the melting process in order to sufficiently eliminate impurities remaining on the surface. Consequently, a high-purity Te₅Sb₂Ge₂ ingot maintaining a purity 99.995 (4N5) was obtained.

Subsequently, the high-purity Ge₂₂Sb₂₂Te₅₆ ingot was pulverized with a ball mill in an inert atmosphere to prepare raw material powder having an average grain size of approximately 30µm, and a maximum grain size of approximately 90µm (one digit of the grain size was rounded off).

Subsequently, the raw material powder was filled in a graphite die having a diameter of 400mm, and subject to the following conditions in an inert atmosphere; namely, a final rise temperature of 600°C at a temperature rise rate of 5°C/min, and a final pressing pressure of 150kgf/cm². Further, as a result of controlling the hot press pressurization pattern to satisfy, with respect to the temperature, the conditions of the following formula: P(pressure) ≦ {Pf/(Tf-T₀)} × (T-T₀) + P₀, (Pf:final pressure, Tf:final temperature, P₀:atmospheric pressure, T: heating temperature, T₀: room temperature, temperatures are in Celsius), a Ge₂₂Sb₂₂Te₅₆ sintered compact was prepared.

In the foregoing case, for instance, based on the foregoing formula, if the room temperature is 25°C, the pressing pressure was strictly adjusted to P≦20kgf/cm² since this will be P (kgf/cm²) ≦{150 (kgf/cm²) / (600°C - 25°C)} x (100°C - 25°C) + 1 (kgf/cm²), at a heating temperature of 100°C. Similarly, the pressing pressure was strictly adjusted to P≦45kgf/cm² at a heating temperature of 200°C and to P≦72kgf/cm² at a heating temperature of 300°C in order to achieve the hot press pressurization pattern according to the foregoing formula.

Specifically, the pressing pressure was set to P=0kgf/cm² when the heating temperature is less than 100°C, to the pressing pressure of P = 20kgf/cm² when the heating temperature is 100 to 200°C, to the pressing pressure of P=45kgf/cm² when the heating temperature is 200 to 300°C, to the pressing pressure of P = 72kgf/cm² when the heating temperature is 300 to the final rise temperature of 600°C, and to the pressing pressure of P=150kgf/cm² when the heating temperature is 600°C.

Incidentally, since the pressing pressure can be gradually increased as described above pursuant to the increase in the heating temperature, the final pressing pressure will reach 150kgf/cm² more quickly. Thus, it can be said that the production time efficiency can be shortened and the production efficiency can be improved by just that much. Nevertheless, an absolute condition is not to deviate from the foregoing formula. Moreover, the sintered compact was retained for 2 hours after reaching the final rise temperature and the final pressing pressure.

In order to measure the density of the obtained sintered compact having a diameter of 400mm, the measurement was performed upon sampling from 9 locations in a cross shape This average value was defined as the sintered compact density. The average value of the deflecting strength was measured by sampling from the middle of the center and the radial direction, and three locations in the peripheral vicinity, and this average value was defined as the deflecting strength.

The average grain size of the sintered compact was calculated from the observation of the structure at nine locations in a cross shape. Consequently, in Example 1, the relative density of the sintered compact was 99.8%, the standard deviation of the variation in the density was <1%, the deflecting strength was 61MPa, and, with respect to the composition of the respective crystal grains, Ge was within the range of 17.8 to 26.6at% and Sb was within the range of 17.8 to 26.6at% (±20%), the average grain size of the sintered compact was 36µm and the maximum grain size was 90µm, and a favorable sintered compact was obtained.

The sintered compact was bonded to a copper alloy backing plate using indium so that the bonding thickness would become 0.9 to 1.4mm. Subsequently, a target plate was prepared by adjusting the polishing process time to achieve a target surface Ra of 0.4µm or less. Consequently, the bonding thickness was 1.1mm, warping after the bonding could not be acknowledged at all, and there were no cracks after the bonding.

Using similar methods, favorable bonding properties have been confirmed regardless of the type of backing plate; regardless of whether they are formed from copper alloy or aluminum alloy.

Subsequently, the target surface Ra was 0.3µm, and the macro pattern was observed during the polishing process, but no macro pattern could be found across the entire target.

Sputtering was performed using this target, and this target had a particle generation rate of 180 particles or less, and showed a particle generation rate that is equal to even less than a conventional high quality, high-density small-sized target (diameter 280mm).

### (Example 1-1)

In addition to the conditions of Example 1, as a result of adding a fluctuation during the solidification of the cast ingot, it was possible to obtain a sintered compact having composition uniformity in which, with respective to the composition of the respective crystal grains, Ge is within the range 20.0 to 24.4at% and Sb is within the range of 20.0 to 24.4at% (±10%), average crystal grain size was 34µm and maximum grain size was 80µm yielding a fine structure, oxygen concentration was 1500ppm, relative density was 99.7%, standard deviation in the variation of the density was <1%, and deflecting strength was 65MPa.

Subsequently, using the same process as Example 1, a target having a bonding thickness of 0.5mm and a target surface Ra of 0.3µm was prepared, and sputtering evaluation was conducted. Consequently, this target had a particle generation rate of 160 particles or less, and showed a particle generation rate that is equal to even less than a conventional high quality, high-density small-sized target (diameter 280mm).

### (Example 1-2)

In addition to the conditions of Example 1, as a result of accelerating the rate of cooling the alloy by introducing inert gas, it was possible to obtain a sintered compact having composition uniformity in which, with respective to the composition of the respective crystal grains, Ge is within the range 21.1 to 23.3at% and Sb is within the range of 21.1 to 23.3at% (±5%), average crystal grain size was 8.6µm and maximum grain size was 40µm yielding a fine structure, oxygen concentration was 830ppm, relative density was 99.6%, standard deviation in the variation of the density was <1%, and deflecting strength was 67MPa. Subsequently, using the same process as Example 1, a target having a bonding thickness of 0.4mm and a target surface Ra of 0.4µm was prepared, and sputtering evaluation was conducted. Consequently, the particle generation rate was 90 particles or less and showed favorable results.

### (Example 1-3)

In addition to the conditions of Example 1-2, as a result of performing additional pulverization using a jet mill, it was possible to obtain a sintered compact having composition uniformity in which, with respective to the composition of the respective crystal grains, Ge is within the range 21.1 to 23.3at% and Sb is within the range of 21.1 to 23.3at% (±5%), average crystal grain size was 2.2µm and maximum grain size was 8µm yielding an ultrafine structure, oxygen concentration was 1900ppm, relative density was 99.8%, standard deviation in the variation of the density was <1%, and deflecting strength was 90MPa. Subsequently, using the same process as Example 1, a target having a bonding thickness of 0.6mm and a target surface Ra of 0.3µm was prepared, and sputtering evaluation was conducted. Consequently, the particle generation rate was 50 particles or less and showed extremely favorable results.

### (Example 1-4)

In addition to the conditions of Example 1, as a result of handling the alloy powder in an inert atmosphere glove box, it was possible to obtain a sintered compact having composition uniformity in which, with respective to the composition of the respective crystal grains, Ge is within the range 17.8 to 26.6at% and Sb is within the range of 17.8 to 26.6at% (±20%), average crystal grain size was 3µm and maximum grain size was 85µm yielding a fine structure, oxygen concentration was 350ppm, relative density was 99.7%, standard deviation in the variation of the density was <1%, and deflecting strength was 70MPa.

Subsequently, using the same process as Example 1, a target having a bonding thickness of 0.7mm and a target surface Ra of 0.3µm was prepared, and sputtering evaluation was conducted. Consequently, the particle generation rate was 110 particles or less and showed favorable results.

### (Example 1-5)

In addition to the conditions of Example 1-3, as a result of performing additional pulverization to the alloy powder in a jet mill using inert atmosphere gas and subsequently handling the powder in an inert atmosphere glove box, it was possible to obtain a sintered compact having composition uniformity in which, with respective to the composition of the respective crystal grains, Ge is within the range 21.1 to 23.3at% and Sb is within the range of 21.1 to 23.3at% (±5%), average crystal grain size was 2.1µm and maximum grain size was 7µm yielding an ultrafine structure, oxygen concentration was 480ppm, relative density was 99.8%, standard deviation in the variation of the density was <1%, and deflecting strength was 105MPa.

Subsequently, using the same process as Example 1, a target having a bonding thickness of 0.5mm and a target surface Ra of 0.3µm was prepared, and sputtering evaluation was conducted. Consequently, the particle generation rate was 25 particles or less and showed extremely favorable results.

### (Example 2)

Ag, In, Sb, Te powder raw materials respectively having a purity of 4N5 excluding gas components were used and blended to achieve a Ag₅In₅Sb₇₀Te₂₀ alloy, and, under the same conditions as Example 1, a sintered compact having a purity of 4N5 and a composition of Ag₅In₅Sb₇₀Te₂₀ was obtained. Specifically, excluding the component composition, a sintered compact was prepared to coincide will the conditions of Example 1.

In order to measure the density of the sintered compact having a diameter of 400mm prepared in Example 2, the measurement was performed upon sampling from nine locations in a cross shape. This average value was defined as the sintered compact density. The average value of the deflecting strength was measured by sampling from the middle of the center and the radial direction, and three locations in the peripheral vicinity, and this average value was defined as the deflecting strength. The average grain size of the sintered compact was calculated from the observation of the structure at nine locations in a cross shape.

Consequently, in Example 2, the relative density of the sintered compact was 99.8%, the standard deviation of the variation in the density was <1%, the deflecting strength was 51MPa, and the average grain size of the sintered compact was 38µm, and a favorable sintered compact was obtained.

### (Example 3)

### (Assembly of target and backing plate)

The sintered compact prepared in Example 2 was bonded to a copper alloy backing plate using indium so that the bonding thickness would become 0.9 to 1.4mm. Subsequently, a target plate was prepared by adjusting the polishing process time to achieve a target surface Ra of 0.4µm or less. Consequently, the bonding thickness was 1.1mm, and the target surface Ra was 0.3µm.

Consequently, as with Example 1, warping after the bonding could not be acknowledged at all, and there were no cracks after the bonding. In the foregoing case, favorable bonding properties have been confirmed regardless of the type of backing plate; regardless of whether they are formed from copper alloy or aluminum alloy. In addition, the macro pattern was observed during the polishing process, but no macro pattern could be found across the entire target.

Sputtering was performed using this target, and this target had a particle generation rate of 200 particles or less, and showed a particle generation rate that is equal to or less than a conventional high quality, high-density small-sized target (diameter 280mm).

Although not shown in the Examples, the sintered compacts and the targets produced therefrom containing other chalcogenide elements (A) and Vb group elements (B) as well as other IVb group elements (C) or additive elements (D) were all favorable sintered compacts as with Example 1 and Example 2 in which the relative density of the sintered compact was 99.8% or higher, standard deviation in the variation of the density was <1%, deflecting strength was 60MPa or more, and average grain size of the sintered compact was 36µm or less.

Moreover, warping after the bonding could not be acknowledged at all, and there were no cracks after the bonding. In addition, the macro pattern was observed during the polishing process, but no macro pattern could be found across the entire target. Sputtering was performed using this target, and this target showed a particle generation rate that is equal to or less than a conventional high quality, high-density small-sized target (diameter 280mm).

### (Comparative Example 1)

The respective raw material powders of Te, Sb and Ge respectively having a purity of 99.995 (4N5) excluding gas components were melted to obtain a composition of Ge₂₂Sb₂₂Te₅₆, and prepare a cast ingot. The raw materials of the respective elements were subject to acid cleaning and deionized water cleaning prior to the melting process in order to sufficiently eliminate impurities remaining on the surface.

Consequently, a high-purity Te₅Sb₂Ge₂ ingot maintaining a purity 99.995 (4N5) was obtained. Subsequently, the high-purity Ge₂₂Sb₂₂Te₅₆ ingot was pulverized with a ball mill in an inert atmosphere to prepare raw material powder having an average grain size of approximately 30µm, and a maximum grain size of approximately 90µm (one digit of the grain size was rounded off). The foregoing conditions are the same as Example 1.

Subsequently, the raw material powder was filled in a graphite die having a diameter of 400mm, and subject to the following conditions in an inert atmosphere; namely, a final rise temperature of 600°C at a temperature rise rate of 15°C/min, and a final pressing pressure of 150kgf/cm². Further, as a result of controlling the hot press pressurization pattern to satisfy, with respect to the temperature, the conditions of the following formula: P(pressure) ≦ {Pf/(Tf-T₀)} × (T-T₀) + P₀, (Pf: final pressure, Tf: final temperature, P₀: atmospheric pressure, T: heating temperature, T₀: room temperature, temperatures are in Celsius), a Ge₂₂Sb₂₂Te₅₆ sintered compact was prepared.

### (Comparative Example 2)

The raw material powder obtained in Comparative Example 1 was filled in a graphite die having a diameter of 400mm, and subject to the following conditions in an inert atmosphere; namely, a final rise temperature of 450°C at a temperature rise rate of 5°C/min, and a final pressing pressure of 150kgf/cm². Further, as a result of controlling the hot press pressurization pattern to satisfy, with respect to the temperature, the conditions of the following formula: P(pressure) ≦ {Pf/(Tf-T₀)} × (T-T₀) + P₀, (Pf: final pressure, Tf: final temperature, P₀:atmospheric pressure, T: heating temperature, T₀: room temperature, temperatures are in Celsius), a Ge₂₂Sb₂₂Te₅₆ sintered compact was prepared.

### (Comparative Example 3)

The raw material powder obtained in Comparative Example 1 was filled in a graphite die having a diameter of 400mm, and subject to the following conditions in an inert atmosphere; namely, a final rise temperature of 600°C at a temperature rise rate of 5°C/min, and a final pressing pressure of 80kgf/cm². Further, as a result of controlling the hot press pressurization pattern to satisfy, with respect to the temperature, the conditions of the following formula: P(pressure) ≦ {Pf/(Tf-T₀)} × (T-T₀) + P₀, (Pf: final pressure, Tf: final temperature, P₀: atmospheric pressure, T: heating temperature, T₀: room temperature, temperatures are in Celsius), a sintered compact was prepared.

### (Comparative Example 4)

The raw material powder obtained in Comparative Example 1 was filled in a graphite die having a diameter of 400mm, and subject to the following conditions in an inert atmosphere; namely, a final rise temperature of 600°C at a temperature rise rate of 5°C/min, and a final pressing pressure of 150kgf/cm². Further, as a result of controlling the hot press pressurization pattern outside the conditions of the following formula: P(pressure) ≦ {Pf/(Tf-T₀)} × (T-T₀) + P₀, (Pf: final pressure, Tf: final temperature, P₀: atmospheric pressure, T: heating temperature, T₀: room temperature, temperatures are in Celsius), a sintered compact was prepared.

As the condition outside the foregoing formula, the pressing pressure was raised to P=75kgf/cm² at the stage when the heating temperature was 100°C in order to accelerate the pressurization process.

As described above, with the conditions of the present invention, based on the foregoing formula, if the room temperature is 25°C, the pressing pressure was strictly adjusted to P≦20kgf/cm² since this will be P (kgf/cm²) ≦{150 (kgf/cm²) / (600°C - 25°C)} × (100°C - 25°C) + 1 (kgf/cm²), at a heating temperature of 100°C. Similarly, the pressing pressure was strictly adjusted to P≦45kgf/cm² at a heating temperature of 200°C and to P≦72kgf/cm² at a heating temperature of 300°C in order to achieve the hot press pressurization pattern according to the foregoing formula. However, the condition of accelerating the pressurization process by raising the pressing pressure to P=75kgf/cm² deviates from the conditions of the present invention.

In order to measure the density of the sintered compact having a diameter of 400mm obtained in Comparative Examples 1 to 4, the measurement was performed upon sampling from nine locations in a cross shape. This average value was defined as the sintered compact density. The average value of the deflecting strength was measured by sampling from the middle of the center and the radial direction, and three locations in the peripheral vicinity, and this average value was defined as the deflecting strength. The average grain size of the sintered compact was calculated from the observation of the structure at nine locations in a cross shape. These measurement conditions are the same as Example 1.

Consequently, in Comparative Example 1, the relative density of the sintered compact was 98.5%, the standard deviation of the variation in the density was 3%, the deflecting strength was 32MPa, and the average grain size of the sintered compact was 42µm, and a fragile sintered compact was obtained.

Similarly, in Comparative Example 2, the relative density of the sintered compact was 94%, the standard deviation of the variation in the density was 1%, the deflecting strength was 26MPa, and the average grain size of the sintered compact was 35µm, and a fragile sintered compact was obtained.

Similarly, in Comparative Example 3, the relative density of the sintered compact was 96.1%, the standard deviation of the variation in the density was 1%, the deflecting strength was 29MPa, and the average grain size of the sintered compact was 39µm, and a fragile sintered compact was obtained.

Similarly, in Comparative Example 4, the relative density of the sintered compact was 99.2%, the standard deviation of the variation in the density was 1%, the deflecting strength was 38MPa, and the average grain size of the sintered compact was 42µm, and a fragile sintered compact was obtained.

The sintered compacts prepared in Comparative Example 1 to 4 were respectively bonded to a copper alloy backing plate using indium so that the bonding thickness would become 0.4 to 1.4mm according to the same process as Example 1. Subsequently, a target plate was prepared by adjusting the polishing process time to achieve a target surface Ra of 0.4µm or less.

Consequently, warping occurred after bonding, and some cracks were observed after the bonding, and a macro pattern was observed in the polishing process, and a macro pattern was observed at various parts of the target. Sputtering was performed using this target, but the particle generation rate was high at 300 to thousands of particles, and was far lower than a practically applicable level.

### (Comparative Example 5)

### (Assembly of target and backing plate)

The sintered compacts prepared in Comparative Example 1 to Comparative Example 4 were used to prepare a target plate having a surface roughness Ra of 0.2µm by adjusting the polishing process time. Subsequently, this target plate was bonded to a copper alloy bonding plate using indium so that the bonding thickness is 0.9mm. Consequently, after bonding, warping occurred and some cracks were observed.

The foregoing results are not limited to a Ge₂₂Sb₂₂Te₅₆ sintered compact, and the sintered compacts and the targets produced therefrom containing other chalcogenide elements (A) and Vb group elements (B) as well as other IVb group elements (C) or additive elements (D) prepared under the same conditions as Comparative Example 1 to Comparative Example 4 all resulted in inferior quality.

### (Comparative Example 6)

Under the conditions of Example 1, by adjusting the ball mill condition, the average grain size of the raw material alloy powder was set to 65µm and the maximum grain size was set to 120µm. In addition, by changing the grain size characteristics of Example 1, obtained was a sintered compact having a relative density of 99.5%, standard deviation in the variation of the density of 1%, average grain size of 60µm, maximum grain size of 115µm, and low deflecting strength of 38MPa.

### (Comparative Example 7)

Under the conditions of Example 1, by adjusting the ball mill condition, the average grain size of the raw material alloy powder was set to 100µm and the maximum grain size was set to 200µm. In addition, by changing the grain size characteristics of Example 1, obtained was a sintered compact having a relative density of 99.4%, standard deviation in the variation of the density of 1.2%, average grain size of 95µm, maximum grain size of 200µm, and a lower deflecting strength of 30MPa.

The sintered compacts prepared in Comparative Example 6 and Comparative Example 7 were respectively bonded to a copper alloy backing plate using indium so that the bonding thickness would be 0.4 to 1.4mm according to the same process as Example 1. Subsequently, a target plate was prepared by adjusting the polishing process time to achieve a target surface Ra of 0.4µm or less. Sputtering was performed using this target, but the particle generation rate was significantly high at 200 to thousands of particles, and the result was unstable.

Based on the Examples and Comparative Examples, it has been confirmed that the desirable condition is that the average grain size of the alloy powder of the elements composing the sintered compact is 50µm or less, and the maximum grain size is 90µm or less. Since the assembly of the target and backing plate can be anticipated based on the foregoing characteristics of the sintered compact, the description of Examples and Reference Examples will be omitted.

### INDUSTRIAL APPLICABILITY

When producing a sintered compact or a sputtering target using raw material powder containing a chalcogenide element (A) and a Vb group element (B) or raw material powder additionally containing a IVb group element (C) or a required additive element (D), since the sintered compact would become extremely fragile, if a large-diameter sputtering target is prepared and this is bonded with a backing plate, there was a problem in that cracks would occur on the target surface or the target itself would crack due to the difference in thermal expansion. The present invention yields a superior effect of producing a high-strength, high-density and large-diameter sintered compact or sputtering target by improving the production process, which is free from cracks even when the target is bonded to the backing plate, and with the warping being within a tolerable range.

Accordingly, upon forming a thin film of a Ge-Sb-Te material or the like as a phase change recording material; that is, as a medium for recording information by using phase transformation, it will be possible to use a larger sputtering target, and the present invention yields superior effects of improving the production efficiency, and producing a uniform phase change recording material.

## Claims

1. A method of producing a sintered compact containing one or more chalcogenide elements (A), one or more Vb group elements (B) below and optionally one or more elements selected from (C) and/or (D) including the steps of:
mixing raw material powder composed of the respective elements or raw material powder of an alloy of two or more elements; and
hot pressing the mixed powder under conditions that satisfy the following formula: P (pressure) ≦{Pf/(Tf-T₀)} × (T-T₀) + P₀ (Pf: final pressure, Tf: final temperature, P₀: atmospheric pressure, T: heating temperature, T₀: room temperature, temperatures are in Celsius,
(A): one or more chalcogenide elements selected from S, Se, and Te;
(B): one or more Vb group elements selected from Bi, Sb, As, P, and N
(C): one or more IVb group elements selected from Pb, Sn, Ge, Si, and C;
and
(D): one or more elements selected from Ag, Au, Pd, Pt, B, Al, Ga, In, Ti, and Zr).

2. The method of producing a sintered compact according to claim 1, containing a maximum of 20at% of the one or more elements selected from (D).

3. The method of producing a sintered compact according to claim 1 or 2, wherein sintering is performed by using raw material powder in which the element (A) is Te, the element (B) is Sb, the element (C) is Ge, and the element (D) is one or more elements selected from Ag, Ga, and In, preferably wherein the sintered compact is one among Ge-Sb-Te, Ag-In-Sb-Te, and Ge-In-Sb-Te.

4. The method of producing a sintered compact according to any one of claims 1 to 3, wherein sintering is performed by using raw material powder of elements constituting the sintered compact in which the raw material powder is composed of an alloy, a compound or a mixture of constituent elementary substances or constituent elements, the average grain size is 0.1µm to 50µm, the maximum grain size is 90µm or less, and the purity is 4N or higher; and/or
wherein, in the course of heating temperature T rising from 100 to 500°C during the hot press, the pressure is maintained at a constant level for 10 to 120 minutes at least in a part of the heating temperature range; and/or
wherein the temperature rise rate from room temperature to final temperature Tf is 10°C/min or less.

5. The method of producing a sintered compact according to any one of claims 1 to 4, wherein the diameter of the sintered compact is 380mm or more.

6. A sintered compact containing one or more chalcogenide elements (A), one or more Vb group elements (B) below and optionally one or more elements selected from (C) and/or (D) below, wherein:
the average crystal grain size of the sintered structure is 50µm or less,
the deflecting strength is 40MPa or more,
the relative density is 99% or higher,
the standard deviation of the relative density is less than 1%, and
the variation in the composition of the crystal grains of each of the elements configuring the compact is less than ±20% of the overall average composition
((A): one or more chalcogenide elements selected from S, Se, and Te;
(B): one or more Vb group elements selected from Bi, Sb, As, P, and N;
(C): one or more IVb group elements selected from Pb, Sn, Ge, Si, and C; and
(D): one or more elements selected from Ag, Au, Pd, Pt, B, Al, Ga, In, Ti, and Zr).

7. The sintered compact according to claim 6, containing a maximum of 20at% of the one or more elements selected from (D).

8. The sintered compact according to claim 6 or 7, wherein the average crystal grain size is 10µm or less; OR 3µm or less.

9. The sintered compact according to claim 6, 7 or 8, wherein the deflecting strength is 60MPa or more; OR 80MPa or more.

10. The sintered compact according to any one of claims 6 to 9, wherein the variation in the composition of the crystal grains of each of the elements configuring the compact is less than ±10% of the overall average composition; OR wherein the variation in the composition of the crystal grains of each of the elements configuring the compact is less than ±5% of the overall average composition.

11. The sintered compact according to any one of claims 6 to 10, wherein the oxygen concentration of the target is 2000ppm or less; OR 1000ppm or less; OR 500ppm or less.

12. The sintered compact according to any one of claims 6 to 11, wherein the element (A) is Te, the element (B) is Sb, the element (C) is Ge, and the element (D) is one or more elements selected from Ag, Ga, and In, preferably wherein the sintered compact is one among Ge-Sb-Te, Ag-In-Sb-Te, and Ge-In-Sb-Te.

13. A sputtering target formed from the sintered compact according to any one of claims 6 to 12.

14. The sputtering target according to claim 13, wherein the target surface is free from a streaked pattern caused by the alignment of coarse grains, and the surface roughness Ra is 0.4µm or less.

15. A sputtering target-backing plate assembly formed by bonding the sputtering target according to claim 13 or 14 to a copper alloy or an aluminum alloy backing plate via a bonding layer composed of low-melting-point metal, preferably wherein the low-melting-point metal is indium.

## Patentansprüche

1. Verfahren zur Produktion eines gesinterten Presskörpers, enthaltend ein oder mehrere Chalkogenid-Elemente (A), eine oder mehrere Elemente der Gruppe Vb (B) im Folgenden und optional ein oder mehrere Elemente, die aus (C) und/oder (D) ausgewählt sind, beinhaltend die Schritte:
Mischen von Rohstoffpulver, das sich aus den jeweiligen Elementen zusammensetzt, oder Rohstoffpulver einer Legierung von zwei oder mehr Elementen und
Heißpressen des gemischten Pulvers unter Bedingungen, die die folgende Formel erfüllen: P (Druck) ≦ {Pf/(Tf-T₀)} ^{∗} (T-T₀) + P₀ (Pf: Enddruck, Tf: Endtemperatur, P₀: Atmosphärendruck, T: Heiztemperatur, T₀: Raumtemperatur, Temperaturen sind in Celsius,
(A): ein oder mehrere Chalkogenid-Elemente, die aus S, Se und Te ausgewählt sind;
(B): ein oder mehrere Elemente der Gruppe Vb, die aus Bi, Sb, As, P und N ausgewählt sind;
(C): ein oder mehrere Elemente der Gruppe IVb, die aus Pb, Sn, Ge, Si und C ausgewählt sind; und
(D): ein oder mehrere Elemente, die aus Ag, Au, Pd, Pt, B, AI, Ga, In, Ti und Zr ausgewählt sind.

2. Verfahren zur Produktion eines gesinterten Presskörpers nach Anspruch 1, enthaltend maximal 20 Atom-% des einen oder der mehreren Elemente, die aus (D) ausgewählt sind.

3. Verfahren zur Produktion eines gesinterten Presskörpers nach Anspruch 1 oder 2, wobei das Sintern durch Verwenden von Rohstoffpulver durchgeführt wird, in dem das Element (A) Te ist, das Element (B) Sb ist, das Element (C) Ge ist und es sich bei dem Element (D) um ein oder mehrere Elemente handelt, die aus Ag, Ga und In ausgewählt sind, vorzugsweise wobei der gesinterte Presskörper einer aus Ge-Sb-Te, Ag-In-Sb-Te und Ge-In-Sb-Te ist.

4. Verfahren zur Produktion eines gesinterten Presskörpers nach einem der Ansprüche 1 bis 3, wobei das Sintern durch Verwenden von Rohstoffpulver von Elementen, die den gesinterten Presskörper bilden, durchgeführt wird, in dem das Rohstoffpulver sich aus einer Legierung, einer Verbindung oder einem Gemisch von konstituierenden elementaren Substanzen oder konstituierenden Elementen zusammensetzt, wobei die durchschnittliche Korngröße 0,1 µm bis 50 µm ist, die maximale Korngröße 90 µm oder weniger ist und die Reinheit 4 N oder höher ist; und/oder
wobei im Verlauf des Ansteigens der Heiztemperatur T von 100 auf 500 °C während des Heißpressens der Druck für 10 bis 120 Minuten auf einem konstanten Niveau zumindest in einem Teil des Heiztemperaturbereichs gehalten wird; und/oder
wobei die Temperaturanstiegsrate von Raumtemperatur zur Endtemperatur Tf 10 °C/min oder weniger ist.

5. Verfahren zur Produktion eines gesinterten Presskörpers nach einem der Ansprüche 1 bis 4, wobei der Durchmesser des gesinterten Presskörpers 380 mm oder mehr ist.

6. Gesinterter Presskörper, enthaltend ein oder mehrere Chalkogenid-Elemente (A), eine oder mehrere Elemente der Gruppe Vb (B) im Folgenden und optional ein oder mehrere Elemente, die aus (C) und/oder (D) im Folgenden ausgewählt sind, wobei:
die durchschnittliche Kristallkorngröße der gesinterten Struktur 50 µm oder weniger ist;
die Ablenkstärke 40 MPa oder mehr ist,
die relative Dichte 99 % oder höher ist,
die Standardabweichung der relativen Dichte weniger als 1 % ist und
die Variation in der Zusammensetzung der Kristallkörner von jedem der Elemente, die den Presskörper konfigurieren, weniger als ± 20 % der durchschnittlichen Gesamtzusammensetzung ist;
((A): ein oder mehrere Chalkogenid-Elemente, die aus S, Se und Te ausgewählt sind;
(B): ein oder mehrere Elemente der Gruppe Vb, die aus Bi, Sb, As, P und N ausgewählt sind;
(C): ein oder mehrere Elemente der Gruppe IVb, die aus Pb, Sn, Ge, Si und C ausgewählt sind; und
(D): ein oder mehrere Elemente, die aus Ag, Au, Pd, Pt, B, AI, Ga, In, Ti und Zr ausgewählt sind).

7. Gesinterter Presskörper nach Anspruch 6, enthaltend maximal 20 Atom-% des einen oder der mehreren Elemente, die aus (D) ausgewählt sind.

8. Gesinterter Presskörper nach Anspruch 6 oder 7, wobei die durchschnittliche Kristallkorngröße 10 µm oder weniger ODER 3 µm oder weniger ist.

9. Gesinterter Presskörper nach Anspruch 6, 7 oder 8, wobei die Ablenkstärke 60 MPa oder mehr ODER 80 MPa oder mehr ist.

10. Gesinterter Presskörper nach einem der Ansprüche 6 bis 9, wobei die Variation in der Zusammensetzung der Kristallkörner von jedem der Elemente, die den Presskörper konfigurieren, weniger als ± 10 % der durchschnittlichen Gesamtzusammensetzung ist ODER wobei die Variation in der Zusammensetzung der Kristallkörner von jedem der Elemente, die den Presskörper konfigurieren, weniger als ± 5 % der durchschnittlichen Gesamtzusammensetzung ist.

11. Gesinterter Presskörper nach einem der Ansprüche 6 bis 10, wobei die Sauerstoffkonzentration des Targets 2000 ppm oder weniger ODER 1000 ppm oder weniger oder 500 ppm oder weniger ist.

12. Gesinterter Presskörper nach einem der Ansprüche 6 bis 11, wobei das Element (A) Te ist, das Element (B) Sb ist, das Element (C) Ge ist und es sich bei dem Element (D) um ein oder mehrere Elemente handelt, die aus Ag, Ga und In ausgewählt sind, vorzugsweise wobei der gesinterte Presskörper einer aus Ge-Sb-Te, Ag-In-Sb-Te und Ge-In-Sb-Te ist.

13. Sputtertarget, das aus dem gesinterten Presskörper nach einem der Ansprüche 6 bis 12 gebildet wird.

14. Sputtertarget nach Anspruch 13, wobei die Target-Oberfläche frei von einem streifigen Muster ist, das von der Ausrichtung von groben Körnern verursacht wird, und die Oberflächenrauheit Ra 0,4 µm oder weniger ist.

15. Sputtertarget-Stützplattenanordnung, die durch Bonden des Sputtertargets nach Anspruch 13 oder 14 an eine Kupferlegierungs- oder eine Aluminiumlegierungsstützplatte mittels einer Bonding-Schicht, die sich aus einem Metall mit niedrigem Schmelzpunkt zusammensetzt, gebildet wird, vorzugsweise wobei das Metall mit niedrigem Schmelzpunkt Indium ist.

## Revendications

1. Procédé de production d'un corps fritté contenant un ou plusieurs éléments chalcogénures (A), un ou plusieurs éléments du groupe Vb (B) ci-dessous et éventuellement un ou plusieurs éléments choisis parmi (C) et/ou (D), le procédé comprenant les étapes consistant à :
mélanger une poudre de matière première composée des éléments respectifs ou une poudre de matière première d'un alliage de deux éléments ou plus ; et
pressage à chaud la poudre mélangée dans des conditions qui satisfont à la formule suivante : P (pression) ≤ {Pf/(Tf-T₀)} ^{∗} (T-T₀) + P₀ (Pf : pression finale, Tf : température finale, P₀ : pression atmosphérique, T : température de chauffage, T₀ : température ambiante, les températures sont en Celsius,
(A) : un ou plusieurs éléments chalcogénures choisis parmi S, Se et Te ;
(B) : un ou plusieurs éléments du groupe Vb choisis parmi Bi, Sb, As, P et N ;
(C) : un ou plusieurs éléments du groupe IVb choisis parmi Pb, Sn, Ge, Si et C ;
et
(D) : un ou plusieurs éléments choisis parmi Ag, Au, Pd, Pt, B, Al, Ga, In, Ti et Zr).

2. Procédé de production d'un corps fritté selon la revendication 1, contenant un maximum de 20 % atomique du ou des éléments choisis parmi (D).

3. Procédé de production d'un corps fritté selon la revendication 1 ou 2, dans lequel le frittage est réalisé au moyen d'une poudre de matière première dans laquelle l'élément (A) est Te, l'élément (B) est Sb, l'élément (C) est Ge et l'élément (D) est un ou plusieurs éléments choisis parmi Ag, Ga et In, et de préférence le corps fritté étant Ge-Sb-Te, Ag-In-Sb-Te ou Ge-In-Sb-Te.

4. Procédé de production d'un corps fritté selon l'une quelconque des revendications 1 à 3, dans lequel le frittage est réalisé au moyen d'une poudre de matière première d'éléments constituant le corps fritté, la poudre de matière première étant composée d'un alliage, d'un composé ou d'un mélange de substances élémentaires constituantes ou d'éléments constituants, la taille moyenne des grains étant comprise entre 0,1 µm et 50 µm, la taille maximale des grains étant inférieure ou égale à 90 µm et la pureté étant supérieure ou égale à 4N ; et/ou
dans lequel, au cours du chauffage de la température T qui augmente de 100 à 500 °C pendant le pressage à chaud, la pression est maintenue à un niveau constant pendant 10 à 120 minutes au moins dans une partie de la plage de température de chauffage ; et/ou
dans lequel la vitesse d'augmentation de température de la température ambiante à la température finale Tf est inférieure ou égale à 10 °C/min.

5. Procédé de production d'un corps fritté selon l'une quelconque des revendications 1 à 4, dans lequel le diamètre du corps fritté est supérieur ou égal à 380 nm.

6. Corps fritté contenant un ou plusieurs éléments chalcogénures (A), un ou plusieurs éléments du groupe Vb (B) ci-dessous et éventuellement un ou plusieurs éléments choisis parmi (C) et/ou (D) ci-dessous, et dans lequel :
la taille moyenne des grains de cristal de la structure frittée est inférieure ou égale à 50 µm,
la force de déviation est supérieure ou égale à 40 MPa,
la densité relative est supérieure ou égale à 99 %,
l'écart-type de la densité relative est inférieur à 1 %, et
la variation dans la composition des grains de cristal de chacun des éléments configurant le corps est inférieure à ±20 % de la composition globale moyenne :
((A) : un ou plusieurs éléments chalcogénures choisis parmi S, Se et Te ;
(B) : un ou plusieurs éléments du groupe Vb choisis parmi Bi, Sb, As, P et N ;
(C) : un ou plusieurs éléments du groupe IVb choisis parmi Pb, Sn, Ge, Si et C ; et
(D) : un ou plusieurs éléments choisis parmi Ag, Au, Pd, Pt, B, Al, Ga, In, Ti et Zr).

7. Corps fritté selon la revendication 6, contenant un maximum de 20 % atomique du ou des éléments choisis parmi (D).

8. Corps fritté selon la revendication 6 ou 7, dans lequel la taille moyenne des grains de cristal est inférieure ou égale à 10 µm ; OU inférieure ou égale à 3 µm.

9. Corps fritté selon la revendication 6, 7 ou 8, dans lequel la force de déviation est supérieure ou égale à 60 MPa ; OU supérieure ou égale à 80 MPa.

10. Corps fritté selon l'une quelconque des revendications 6 à 9, dans lequel la variation dans la composition des grains de cristal de chacun des éléments configurant le corps est inférieure à ±10 % de la composition globale moyenne ; OU dans lequel la variation dans la composition des grains de cristal de chacun des éléments configurant le corps est inférieure à ±5 % de la composition globale moyenne.

11. Corps fritté selon l'une quelconque des revendications 6 à 10, dans lequel la concentration d'oxygène de la cible est inférieure ou égale à 2000 ppm ; OU inférieure ou égale à 1000 ppm ; OU inférieure ou égale à 500 ppm.

12. Corps fritté selon l'une quelconque des revendications 6 à 11, dans lequel l'élément (A) est Te, l'élément (B) est Sb, l'élément (C) est Ge et l'élément (D) est un ou plusieurs éléments choisis parmi Ag, Ga et In, et de préférence le corps fritté étant Ge-Sb-Te, Ag-In-Sb-Te ou Ge-In-Sb-Te.

13. Cible de pulvérisation formée à partir du corps fritté selon l'une quelconque des revendications 6 à 12.

14. Cible de pulvérisation selon la revendication 13, dans lequel la surface cible est exempte d'un motif tacheté causé par l'alignement de grains grossiers et la rugosité superficielle Ra est inférieure ou égale à 0,4 µm.

15. Ensemble cible de pulvérisation-plaque d'appui formé en liant la cible de pulvérisation selon la revendication 13 ou 14 à une plaque d'appui en alliage de cuivre ou en alliage d'aluminium par l'intermédiaire d'une couche de liaison composée d'un métal à faible point de fusion, le métal à faible point de fusion étant de préférence l'indium.
